# EUROPÄISCHE PATENTSCHRIFT

(11) **EP 1 606 982 B1**
(45) Veröffentlichungstag und Bekanntmachung des Hinweises auf die Patenterteilung: **17.06.2009**
(21) Anmeldenummer: 04717610.2
(22) Anmeldetag: 05.03.2004
(51) Int. Cl.: H05K 3/36, H05K 1/14

(54) **VERFAHREN ZUR ELEKTRISCHEN UND MECHANISCHEN VERBINDUNG ZWEIER LEITERPLATTEN**
METHOD FOR ELECTRICALLY AND MECHANICALLY CONNECTING TWO PRINTED BOARDS
PROCEDE DE CONNEXION ELECTRIQUE ET MECANIQUE DE DEUX CARTES A CIRCUITS IMPRIMES

(30) Priorität: 26.03.2003 DE 10313622
(43) Veröffentlichungstag der Anmeldung: 21.12.2005
(73) Patentinhaber: SIEMENS AKTIENGESELLSCHAFT, 80333 München (DE)
(72) Erfinder: KRÜGER, Mario, 06420 Könnern (DE); PAUL, Reinhold, 68219 Mannheim (DE); WACKER, Franz, 76684 Östringen (DE)
(86) Internationale Anmeldenummer: PCT/EP2004/002263
(87) Internationale Veröffentlichungsnummer: WO 2004/086831

(56) Entgegenhaltungen:
- EP-A- 0 612 204
- EP-A- 0 825 680
- WO-A-97/43883
- DE-A- 10 229 953
- US-A- 5 036 431
- US-A- 6 081 996
- US-A1- 2003 024 114
- "IMPROVED AREA ARRAY SURFACE MOUNT MODULE PACKAGE" IBM TECHNICAL DISCLOSURE BULLETIN, IBM CORP. NEW YORK, US, Bd. 32, Nr. 9B, 1. Februar 1990 (1990-02-01), Seiten 64-65, XP000082233 ISSN: 0018-8689

## Beschreibung

Die Erfindung betrifft ein Verfahren zur elektrischen und mechanischen Verbindung zweier Leiterplatten mit Hilfe einer Stiftleiste.

Zur gegenseitigen Kontaktierung von Leiterplatten (bzw. Printed Circuit Boards, PCB) sind kraftschlüssige Verbindungen bzw. Einpressverbindungen von Anschlusskämmen bzw. Stiftleisten zwischen den Leiterplatten bekannt.

Ferner ist bekannt, Leiterplatten miteinander über Stiftleisten über ein Lötverfahren miteinander zu kontaktieren und gleichzeitig gegeneinander mechanisch zu fixieren. Die Stiftleisten werden hierbei unter Anwendung eines Wellenlötverfahrens mit Durchkontaktierungen der jeweiligen Leiterplatte verbunden. Üblicherweise ist die Stiftleiste beispielsweise in einem Kunststoffkörper gekapselt und weist Abstandnoppen zur Einstellung eines Freiraums zwischen dem Kunststoffkörper und den Leiterbahnen auf der Leiterplatte auf.

Das Wellenlötverfahren eignet sich für eine Montage von Bauelementen, bei der eine Durchkontaktierung (Through-Hole Technology) von Anschlussdrähten dieser Bauelemente auf die Unterseite der Leiterplatte erfolgt. Die Unterseite der Leiterplatte bildet dabei die Lötseite. Beim eigentlichen Lötvorgang wird die Leiterplatte mit der Lötseite nach unten über eine Welle flüssigen Lots gezogen.

Mit einer zunehmender Miniaturisierung von Bauelementen setzt sich eine Oberflächenmontage (Surface Mounting Technology, SMT) bei der Bestückung von Leiterplatten durch. Ein in Oberflächenmontage aufgebrachtes Bauelement - in der Fachwelt auch als SMD (Surface Mounted Device) bekannt - weist metallisierte Flächen bzw. metallische Anschlussbeinchen auf, die in einem Lötvorgang mit Leiterbahnen der Leiterplatte verbunden werden, wodurch eine Durchkontaktierung von Anschlussdrähten in dafür vorgesehene Bohrungen der Leiterplatte entfällt.

Das für die SMT-Technik eingesetzte Lötverfahren wird in der Fachwelt auch als Aufschmelzlötverfahren bzw. Reflow-Lötverfahren bezeichnet. Es handelt sich hierbei um ein Lötverfahren, bei dem in einem vorausgehenden Arbeitsschritt auf die Leiterplatte aufgebrachte Lotpaste durch Temperatureinwirkung aufgeschmolzen wird, wodurch die Leiterplatte und SMD-Bauelemente miteinander verbunden werden.

Bei einer gängigen Montage einer Leiterplatte auf einen Baugruppenträger - insbesondere einer weiteren Leiterplatte - wird eine erste Leiterplatte mit einer zweiten Leiterplatte durch Stiftleisten derart verbunden, dass die beiden Leiterplattenebenen parallel zueinander angeordnet sind. Anschaulich wird diese Anordnung daher auch als "Sandwich"-Bauweise bezeichnet. Bei der in einem Abstand zur ersten Leiterplatte aufgebrachten zweiten Leiterplatte handelt es sich beispielsweise um ein Submodul, das durch die Stiftleiste mit der ersten Leiterplatten - z.B. einer sogenannten Hauptbaugruppe - elektrisch und mechanisch verbunden wird.

Aus dem Dokument "Improved Area Array Surface Mount Module Package", IBM Technical Disclosure Bulletin, IBM Corp. New York, Band 32, Nr. 9B, 1. Februar 1990, Seiten 64-65, ist eine Anordnung zur elektrischen und mechanischen Verbindung einer Karte mit einem Substrat mittels mehrerer Stifte bekannt. Ein jeweiliges Ende der Stifte wird mittels eines ersten Lötvorgangs auf der Karte verlötet. Anschließend wird das jeweilige andere Ende der Stifte durch Durchgangslöcher des Substrats geführt und in einem zweiten Lötvorgang am Substrat befestigt.

Bei der Fertigung in dieser Sandwich-Bauweise hat es sich als vorteilhaft erwiesen, das Submodul mit Stiftleisten zu versehen und diese Stiftleisten in einem anschließenden SMT-Lötprozess mit entsprechenden Lötstellen auf der Hauptbaugruppe zu verbinden. Die mit der Hauptbaugruppe zu verbindenden Enden der Stiftleisten sind hierzu abgewinkelt, um eine Kontaktfläche mit den Lötstellen zu gewährleisten. Die Geometrie der Stiftleistenenden ist beispielsweise als "Gullwing" oder als "J-Lead" ausgebildet. Zur leichteren Montage des Submoduls auf der Hauptbaugruppe sind Stiftleisten an mindestens zwei Rändern des Submoduls angeordnet, so dass die Submodule vor dem SMT-Lötvorgang auf der Hauptbaugruppe standfest positioniert werden können.

Eine vorausgehende Montage der Stiftleisten am Submodul erfolgt üblicherweise durch Einpressen dieser Stiftleisten in entsprechend vorgesehene kraftschlüssige Bohrungen am Submodul. Eine weitere Alternative zur kraftschlüssigen Montage ist ein Verlöten der Stiftleisten am Submodul.

Die obengenannten Montageverfahren weisen mehrere Nachteile auf. Ein kraftschlüssiges Einpressen der Stiftleisten ist nur für Leiterplattendicken oberhalb von zwei Millimetern geeignet. Das Einpressen muss weiterhin so vollzogen werden, dass sich die kraftschlüssige Verbindung während eines SMT-Lötprozesses nicht löst. Weiterhin verursacht dieser zusätzliche Arbeitsschritt einen Anstieg der Fertigungskosten.

Die Planaritätstoleranz der Submodule muss sehr eng bemessen sein, damit das Submodul koplanar zur Hauptbaugruppe ist. Die Koplanarität der beiden Leiterplatten ist eine Voraussetzung für ein planares Aufliegen aller für die Oberflächenmontage geformten Stiftenden der Stiftleiste auf allen jeweils für ein Stiftende vorgesehenen Lötstellen. Das planare Aufliegen der Stiftenden ist wiederum zwingend notwendig für die Qualität der Lötverbindung der Stiftleisten mit der Hauptbaugruppe. Diese Lötverbindung wird neben dem Fertigungsprozess des Einpressens auch durch eine Verformung des Submoduls während des Lötens bestimmt.

Aufgabe der Erfindung ist es, Mittel anzugeben, bei deren Einsatz ein planares Aufliegen von Stiftleistenenden eines Submoduls auf einer Hauptbaugruppe gewährleistet ist.

Eine Lösung der Aufgabe erfolgt durch ein Verfahren mit den Merkmalen des Patentanspruchs 1.

Erfindungsgemäß werden Stifte einer eine erste Leiterplatte mit einer zweiten Leiterplatte verbindenden Stiftleiste in Durchkontaktierungen der zweiten Leiterplatte durchgeführt und die zweite Leiterplatte in einem Abstand auf der ersten Leiterplatte koplanar positioniert. Die Verbindung der Stiftleiste auf beiden Leiterplatten erfolgt durch einen sich anschließenden Lötvorgang, vorzugsweise einem Aufschmelzlötvorgang. Die Durchkontaktierungen - d.h. die metallisierten Durchgangsbohrungen - weisen dabei einen Querschnitt auf, der gegenüber dem Querschnitt der Stifte genügend Spiel für eine Bewegung der Stifte senkrecht zur Ebene der Leiterplatten lässt. Die auf der ersten Leiterplatte durch die Lötverbindung montierten Stiftenden sind für eine Oberflächenmontage geformt.

Ein wesentlicher Vorteil des erfindungsgemäßen Verfahrens ist darin zu sehen, dass durch die Durchkontaktierungen geführten Stiftleisten während des Lötvorgangs, d.h. in einem aufgeschmolzenen Zustand des Lots, eine senkrecht zur Ebene der Leiterplatten erfolgende Bewegung ermöglicht ist. Durch diese Gestaltung ist eine vorteilhafte Nivellierung von Planaritätstoleranzen während des Lötvorgangs durch das Eigengewicht der zweiten Leiterplatte gewährleistet. Damit spielt eine Toleranz der Koplanarität zwischen der zweiten Leiterplatte und der ersten Leiterplatte für das Ergebnis der Lötverbindung der oberflächenmontierten Stiftenden auf der ersten Leiterplatte keine Rolle.

Mit einem vorteilhaften Entfallen einer bekannten formschlüssigen Einpresstechnik der Stiftleiste in die zweite Leiterplatte sind mit dem erfindungsgemäßen Verfahren auch Leiterplattendicken unterhalb von zwei Millimetern zulässig. Die Gestaltung der zweiten Leiterplatte ist damit vorteilhaft - z.B. als Subbaugruppe - für kleinere Dicken zu fertigen. Ein Verbiegen dieser Subbaugruppe hat auf die Koplanarität der Anschlussleiste bzw. der der ersten Leiterplatte zugewandten, in Oberflächenbausweise montierten Stiftenden keinen Einfluss. Zudem entfällt eine bislang erforderliche enge Mindesttoleranz für die Planarität der Subbaugruppe während eines Fertigungsprozesses.

Ein weiterer Vorteil des erfindungsgemäßen Verfahrens besteht darin, dass die Montage der zweiten auf der ersten Leiterplatte durch lediglich einen Lötvorgang erfolgt. Es entfallen somit in vorteilhafter Weise zusätzliche Lötvorgänge - z.B. mit Hilfe einer Wellenlöttechnik - bzw. Einpressvorgänge, mittels derer bislang eine Montage der Stiftleiste auf der zweiten Leiterplatte erfolgte.

Vorteilhafte Weiterbildungen der Erfindung sind in den Unteransprüchen angegeben.

In vorteilhafter Weise wird ein Aufschmelzlötvorgang unter Verwendung einer Lotpaste für das erfindungsgemäße Verfahren verwendet, da die Aufschmelztechnik der Stiftleiste mit der Montage heute üblicher SMD-Bauteile (Surface Mounted Device) zeitgleich erfolgen kann. Diese bevorzugte Ausgestaltung des erfindungsgemäßen Verfahrens zeichnet sich durch eine Kombination der mechanischen Vorteile von THT-Stiftleisten (Through Hole Technology) mit dem vorzugsweise angewandten Aufschmelzlötverfahren aus. Die Stiftleiste ist gemeinsam mit SMD-Bauteilen in einem einzigen Arbeitsgang zu löten.

Ein dem Aufschmelzlötvorgang vorausgehender zusätzlicher Lötvorgang kann aus Stabilitätsgründen vorteilhaft sein. Die durch diesen Lötvorgang erzeugte Lötverbindung wird durch entsprechende Wahl des Lots bzw. der entsprechenden Prozessparameter so gestaltet, dass diese im folgenden Aufschmelzvorgang wieder aufgeschmolzen wird, um die erfindungsgemäße Wirkung mit einer Erzielung einer planen Auflage der in Oberflächenbauweise geformten Stiftenden auf der ersten Leiterplatte zu gewährleisten.

In vorteilhafter Weise sind die Stifte innerhalb der Stiftleiste durch ein Gehäuse fixiert, das an den der zweiten Leiterplatte zugewandten Seite Abstandshalter aufweist. Das Gehäuse ist vorzugsweise als ein Kunststoff- bzw. Keramikkörper ausgebildet. Die Abstandshalter sind vorzugsweise als Noppen bzw. Kunststoffnasen ausgebildet und gewährleisten ein senkrechtes Aufliegen der Stiftleiste auf der zweiten Leiterplatte sowie einen freien Lotdurchstieg, in der Fachwelt auch mit "Stand off" bezeichnet.

Ein Ausführungsbeispiel mit weiteren Vorteilen und Ausgestaltungen der Erfindung wird im folgenden anhand der Zeichnung näher erläutert.

### Dabei zeigen:

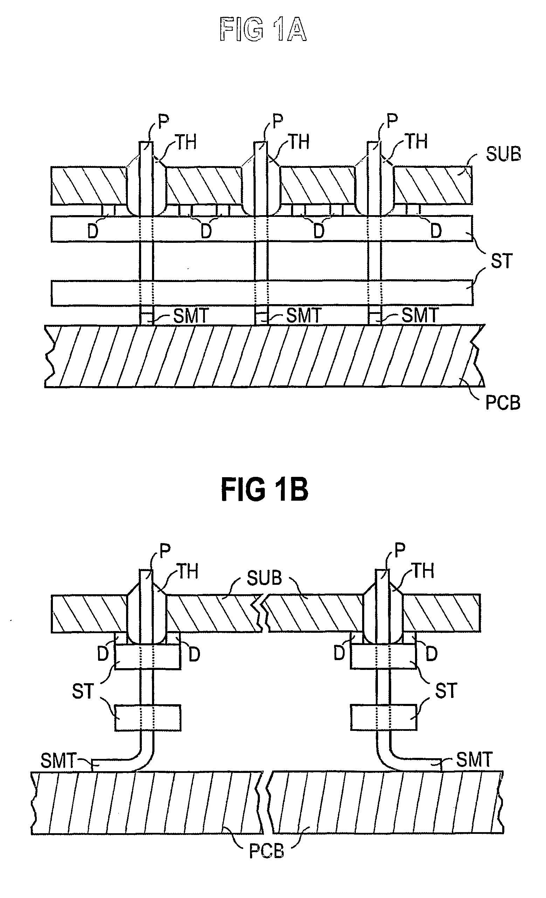

- Fig. 1A:: ein Strukturbild zur schematischen Darstellung einer Leiterplattenverbindung in einer ersten Ansicht; und
- Fig. 1B:: ein Strukturbild zur schematischen Darstellung einer Leiterplattenverbindung in einer gegenüber der ersten Ansicht um 90° gedrehten Ansicht.

In Fig. 1A ist ein Schnitt einer ersten Leiterplatte PCB und einer zweiten Leiterplatte SUB dargestellt. Die erste Leiterplatte PCB ist beispielsweise als Hauptbaugruppe PCB, die zweite Leiterplatte ist beispielsweise aus Submodul SUB ausgeführt.

Die beiden Leiterplatten PCB,SUB sind mit einer Stiftleiste ST mechanisch miteinander verbunden, wobei die Verbindung koplanar unter Ausbildung eines Abstands zwischen den leiterplatten PCB,SUB ausgebildet ist.

In der mit einem isolierenden Material - z.B. Kunststoff oder Keramik - ausgebildeten Stiftleiste ST verlaufen Stifte P, welche an der der Hauptbaugruppe PCB zugewandten Seite eine Oberflächenmontage geeignete Form SMT aufweisen. Die Stiftleiste ST ist beispielsweise in einem Kunststoff- oder Keramikkörper gekapselt.

Die Stifte P werden an der dem Submodul SUB zugewandten Seite in Durchkontaktierungen TH eingeführt. Die Durchkontaktierungen TH sind beispielsweise als entsprechende Bohrungen ausgeführt, welche in einem vorausgehenden Prozess metallisiert wurden. Auf der Oberseite des Submoduls sind neben - nicht dargestellten - Leiterbahnen auch - nicht dargestellte - metallisierte Lötstellen ("Pads") vorgesehen, in die die Metallschicht der Durchkontaktierungen TH münden.

Vor einem Durchstecken der Stifte P in die Durchkontaktierungen TH wird an den zugehörigen Lötstellen Lotpaste aufgetragen. Dieser Prozess wird in der Fachwelt auch mit "Pin in Paste" bezeichnet. Die Lotpaste wird in gleicher Weise an den für die Oberflächenmontage geformten Stifte SMT vorgesehenen - nicht dargestellten - Lötstellen an der Hauptbaugruppe PCB aufgebracht. Der Pin-In-Paste-Prozess beginnt mit dem Aufbringen der Lotpaste auf die Leiterplatte SUB, welche z.B. in Siebdrucktechnik erfolgt. Ist die Aufbringung abgeschlossen, erfolgt das Aufsetzen von - nicht dargestellten - SMD-Bauelementen auf die Leiterplatte, bevor die Stifte P der Stiftleiste ST in die mit Paste gefüllten Durchkontaktierungen TH eingesteckt werden. Alternativ werden die Stiftleisten vor den SMD-Baulelementen platziert.

Die mechanische und elektrische Verbindung der Stifte SMT,P auf der jeweiligen Leiterplatte PCB,SUB erfolgt in einem anschließenden Reflow- bzw. Aufschmelzlötprozess. Der Querschnitt der Durchkontaktierungen TH ist so groß gewählt, dass sich die Stifte P der Stiftleiste ST innerhalb der Durchkontaktierung TH während des Aufschmelzlötprozesses in Richtung einer Normalen auf der Leiterplattenebene frei bewegen kann. Die Stiftleiste ST wird während des Aufschmelzlötvorgangs mittels Abstandshaltern D - z.B. Noppen - senkrecht auf der Leiterplatte gehalten. Neben dieser Gewährleistung eines senkrechten Aufliegens bewirken die Abstandshalter D eine Einstellung eines Freiraums zwischen dem Kunststoff- oder Keramikkörper der Stiftleiste ST und den - nicht dargestellten - Leiterbahnen auf der Unterseite des Submoduls SUB. Weiterhin gewährleisten die Abstandshalter D einen freien Lotdurchstieg der aufgeschmolzenen Lotpaste innerhalb der Durchkontaktierung TH.

Während des Lötvorgangs in einem beispielsweise mit inerten Gas gefüllten Ofen schmilzt die an den jeweiligen Stellen aufgebrachte Lotpaste auf und verbindet sich mit den umgebenden metallischen bzw. metallisierten Oberflächen. Bei der Stiftleiste ST schmilzt die THT-Lötstelle in der Durchkontaktierung TH auf und das Eigengewicht des Submoduls SUB drückt die für die Oberflächemontage geformten Stiftenden SMT auf der Hauptbaugruppe PCB auf die - nicht dargestellten - Pads planar auf. Dabei lösen sich vorher "eingefrorene" nichtplanare Ausprägungen in der Stiftleiste ST bzw. im Submodul SUB auf. Durch die freie Beweglichkeit der Stifte P in den Durchkontaktierungen TH ist eine Nivellierung dieser nichtplanaren Ausprägungen durch die Einwirkung des Eigengewichts des Submoduls SUB gewährleistet, so dass die für die Oberflächemontage geformten Stiftenden SMT planar und parallel auf der Ebene der Hauptbaugruppe PCB aufliegen. Nach dem Aushärten des Lots ist eine zuverlässige Lötverbindung gewährleistet.

Die Durchkontaktierung TH ist in der Zeichnung nach diesem erfolgten Lötvorgang mit jeweils ausgehärteten Lot dargestellt. Auf der Unterseite sowie auf der Oberseite des Submoduls SUB haben sich auf den metallisierten, mit der Durchkontaktierung TH verbundenen Lötstellen konvexe bzw. hohlkegelförmige Lotwülste gebildet.

Bisher war für die Bestückung von Leiterplatten mit einer Stiftleiste ST in der Regel ein separater Arbeitsschritt erforderlich. Der Stiftleiste ST wurde hierbei nach dem Reflow-Löten der SMD-Bauelemente - manuell oder per Automat - eingesetzt und verlötet. Dieser Schritt entfällt mit dem erfindungsgemäßen Verfahren, was die Kosten für eine Bestückung einer Baugruppe stark reduziert.

Im folgenden wird unter weiterer Bezugnahme auf die Funktionseinheiten der Fig. 1 die Anordnung des Submoduls SUB näher erläutert.

In der Seitenansicht gemäß Fig. 1B ist ersichtlich, dass das Submodul SUB in der bevorzugten Ausführungsform zwei Stiftleisten ST aufweist, wodurch eine Positionierung der Stiftleiste ST bzw. des Submoduls SUB auf der Hauptbaugruppe PCB ohne weitere Positionierungseinrichtungen möglich ist. Selbstverständlich ist eine Anwendung des erfindungsgemäßen Verfahrens auch für eine Positionierung einer einzigen Stiftleiste ST durchführbar.

Weiterhin zeigt die Seitenansicht schematisch eine beispielhafte Geometrie der für die Oberflächemontage geformten Stiftenden SMT, die ohne weiteres durch weitere gattungsmäßig übliche Geometrien ersetzbar ist. Des weiteren ist eine kugelförmige Ausprägung der Stifleistenenden SMT einsetzbar.

## Patentansprüche

1. Verfahren zur elektrischen und mechanischen Verbindung einer ersten Leiterplatte (PCB) mit einer in einem Abstand zur ersten Leiterplatte (PCB) koplanar angeordneten zweiten Leiterplatte (SUB) mittels einer mehrere Stifte (P) aufweisenden Stiftleiste (ST), mit folgenden Schritten:
- Durchführung der Stifte (P) in Durchkontaktierungen (TH) der zweiten Leiterplatte (SUB), wobei die Durchkontaktierungen (TH) einen Querschnitt aufweisen, der eine Bewegung der durchgeführten Stifte (P) senkrecht zur Ebene der Leiterplatten (PCB,SUB) gewährleistet,
- Positionierung der für eine Oberflächenmontage geformten Stiftenden (SMT) der Stiftleiste (ST) an vorgesehenen Stellen der ersten Leiterplatte (PCB),
- Montage der Stiftleiste (ST) auf der ersten und der zweiten Leiterplatte (PCB, SUB) durch lediglich einen Lötvorgang.

2. Verfahren nach Anspruch 1,
**dadurch gekennzeichnet,**
**dass** der Lötvorgang als Aufschmelzlötvorgang erfolgt.

3. Verfahren nach einem der Ansprüche 1 oder 2,
**dadurch gekennzeichnet, dass**
vor der Durchführung der Stifte eine Aufbringung von Lotpaste auf die zweite Leiterplatte (SUB) erfolgt.

4. Verfahren nach einem der Ansprüche 2 oder 3,
**dadurch gekennzeichnet, dass**
nach der Durchführung der Stifte ein dem Aufschmelzlötvorgang vorausgehender Lötvorgang zur Montage der Stiftleiste an der zweiten Leiterplatte (SUB) erfolgt.

5. Verfahren nach einem der vorhergehenden Ansprüche,
**dadurch gekennzeichnet, dass**
die Stifte (P) in der Stiftleiste (ST) durch ein umschließendes Gehäuse örtlich fixiert werden.

6. Verfahren nach einem der vorhergehenden Ansprüche,
**gekennzeichnet dadurch,**
**dass** ein freier Lotdurchstieg in den Durchkontaktierungen (TH) während des Lötvorgangs durch der Stiftleiste (ST) zugeordnete Abstandshalter (D) gewährleistet wird.

## Claims

1. Method for electrical and mechanical connection of a first circuit board (PCB) with a second circuit board (SUB) arranged in a coplanar manner at a distance to the first circuit board (PCB) by means of a pin contact strip (ST) featuring a plurality of pins (P), with the following steps:
- Pushing the pins (P) into through-holes (TH) of the second circuit board (SUB), with the through-holes (TH) having a cross-section which allows the introduced pins (P) to move freely at right angles to the plane of the printed circuit boards (PCB, SUB),
- Positioning of the pin ends (SMT) of the pin contact strip (ST) formed for surface mounting at locations provided on the first circuit board (PCB),
- Mounting the pin contact strip (ST) on the first and the second circuit board (PCB, SUB) by means of just one soldering process.

2. Method according to claim 1,
**characterised in that**,
the soldering is undertaken as reflow soldering.

3. Method according to one of the claims 1 or 2,
**characterised in that**,
before the pins are passed through the holes solder paste is applied to the second circuit board (SUB).

4. Method according to one of the claims 2 or 3,
**characterized in that**
after the pins are passed through the holes a soldering process prior to the reflow soldering process is undertaken to mount the pin contact strip on the second circuit board (SUB).

5. Method according to one of the previous claims,
**characterised in that**,
the pins (P) in the pin contact strip (ST) are fixed locally by a surrounding housing.

6. The method as claimed in one of the previous claims,
**characterized in that**
a free upwards passage of solder into the through-holes(TH) is guaranteed during the soldering process by spacers (D) assigned to the pin contact strip (ST).

## Revendications

1. Procédé pour relier électriquement et mécaniquement une première carte de circuit imprimé (PCB) à une deuxième carte de circuit (SUB) imprimé disposée de façon coplanaire à une distance d'une première carte de circuit imprimé (PCB) au moyen d'une bande (ST) de broches de contact présentant plusieurs broches (P), avec les étapes suivantes :
- le passage des broches (P) dans des trous d'interconnexion (TH) de la deuxième carte de circuit imprimé (SUB), les trous d'interconnexion (TH) présentant une section, qui garantit un déplacement des broches interconnectées (P) perpendiculairement au plan des cartes de circuit imprimé (PCB, SUB),
- le positionnement des extrémités de broche façonnées pour un montage en surface (SMT) de la bande de broches de contact (ST) aux emplacements prévus de la première carte de circuit imprimé (PCB),
- le montage de la bande de broches de contact (ST) sur la première et la deuxième carte de circuit imprimé (PCB, SUB) à l'aide de seulement un processus de soudage.

2. Procédé selon la revendication 1,
**caractérisé en ce que**,
le processus de soudage se réalise en tant que processus de brasage par fusion.

3. Procédé selon l'une quelconque des revendications 1 ou 2,
**caractérisé en ce que**,
une application de pâte à souder a lieu sur la deuxième carte de circuit imprimé (SUB) avant le passage des broches

4. Procédé selon l'une quelconque des revendications 2 ou 3,
**caractérisé en ce que**,
un processus de soudage précédant le processus de soudage par fusion a lieu pour monter la bande de broches de contact sur la deuxième carte de circuit imprimé (SUB) après le passage des broches.

5. Procédé selon l'une quelconque des revendications précédentes,
**caractérisé en ce que**,
les broches (P) sont fixées localement dans la bande de broches de contact (ST) à l'aide d'un boîtier qui les enveloppe.

6. Procédé selon l'une quelconque des revendications précédentes,
**caractérisé en ce que**,
pendant le processus de soudage, un passage libre de la soudure dans les trous d'interconnexion (TH) est garanti par des entretoises (D) associées à la bande de broches de contact (ST).
